# EUROPEAN PATENT APPLICATION

(11) **EP 4 642 209 A1**
(43) Date of publication of application: **29.10.2025**
(21) Application number: 25167068.3
(22) Date of filing: 28.03.2025
(51) Int. Cl.: H10K 71/12, H10K 85/50, H10K 71/00, H10K 30/50

(54) **MANUFACTURING DEVICE AND MANUFACTURING METHOD FOR PEROVSKITE SOLAR CELL**

(30) Priority: 23.04.2024 JP 2024069780
(71) Applicant: TOYOTA JIDOSHA KABUSHIKI KAISHA, Toyota-shi, Aichi-ken, 471-8571 (JP)
(72) Inventor: MATSUNOBU, Kohei, Toyota-shi, 471-8571 (JP); OKUMURA, Kenichi, Toyota-shi, 471-8571 (JP)
(74) Representative: J A Kemp LLP

(57) **Abstract**

Provided is a manufacturing device and a manufacturing method for a perovskite solar cell capable of suppressing generation of pinholes in a photoelectric conversion layer. The manufacturing device 1 for a perovskite solar cell is a device for manufacturing a perovskite solar cell including a photoelectric conversion layer containing a perovskite compound, and includes a precursor solution application unit 11 that applies a precursor solution containing the perovskite compound as a solute over an application surface; a poor solvent application unit 12 that applies a poor solvent having a lower solubility for the perovskite compound than that of a solvent of the precursor solution over the application surface with the precursor solution applied; and a ventilation unit 13 that ventilates a vicinity of the application surface.

## Description

### Technical Field

The present invention relates to a manufacturing device and a manufacturing method for a perovskite solar cell.

### Background Art

As one type of solar cells, a perovskite solar cell using a perovskite compound as a main component of a photoelectric conversion layer has been known.

As a method for forming a photoelectric conversion layer containing a perovskite compound, for example, Patent Literature 1 describes a method in which a material film of a perovskite film is applied, and then a poor solvent in a gaseous or a mist form is sprayed onto the material film and the material film is dried and crystallized.

### Citation List

### Patent Literature

Patent Literature 1: JP 2023-148126 A

### Summary of Invention

### Technical Problem

However, such a conventional manufacturing method for a perovskite solar cell has occasionally generated pinholes in a photoelectric conversion layer. Pinholes generated in the photoelectric conversion layer cause a decline in the power generation performance of a solar cell and could cause a short circuit.

The present invention has been made to overcome such technical problems and provides a manufacturing device and a manufacturing method for a perovskite solar cell that can suppress generation of pinholes in a photoelectric conversion layer.

### Solution to Problem

A manufacturing device for a perovskite solar cell according to the present invention is a manufacturing device for a perovskite solar cell including a photoelectric conversion layer containing a perovskite compound, the manufacturing device including: a precursor solution application unit that applies a precursor solution containing the perovskite compound as a solute over an application surface; a poor solvent application unit that applies a poor solvent having a lower solubility for the perovskite compound than a solubility for the perovskite compound of a solvent of the precursor solution over the application surface with the precursor solution applied; and a ventilation unit that ventilates a vicinity of the application surface.

Since the manufacturing device for a perovskite solar cell according to the present invention includes the ventilation unit that ventilates the vicinity of the application surface with the precursor solution applied, the vicinity of the application surface is ventilated, thereby enabling the gas concentration of an organic compound in the vicinity of the application surface to be reduced. As a result, the crystal nuclei of the perovskite compound can be uniformly formed in a plane, so that generation of pinholes in the photoelectric conversion layer can be suppressed.

In some embodiments, the manufacturing device for a perovskite solar cell according to the present invention further includes: a gas concentration detection unit that detects a gas concentration of an organic compound in the vicinity of the application surface; and a control device that controls a ventilation amount by the ventilation unit, in which the control device controls the ventilation amount by the ventilation unit based on the gas concentration of the organic compound in the vicinity of the application surface detected by the gas concentration detection unit. In this manner, generation of pinholes in the photoelectric conversion layer can be suppressed and the surface roughness of the photoelectric conversion layer can be reduced.

In some embodiments, in the manufacturing device for a perovskite solar cell according to the present invention, the control device controls the ventilation amount by the ventilation unit such that the gas concentration of an organic compound in the vicinity of the application surface falls within a preset range. In this manner, generation of pinholes in the photoelectric conversion layer can be further suppressed and the surface roughness of the photoelectric conversion layer can be reduced.

In some embodiments, in the manufacturing device for a perovskite solar cell according to the present invention, the ventilation unit includes an exhaust section that exhausts gas in the vicinity of the application surface. In this manner, the variation of the ventilation unit can be increased, so that the versatility of the manufacturing device can be increased.

In some embodiments, in the manufacturing device for a perovskite solar cell according to the present invention, the ventilation unit includes an air blowing section that blows air to the vicinity of the application surface. In this manner, the variation of the ventilation unit can be increased, so that the versatility of the manufacturing device can be increased.

Further, a manufacturing method for a perovskite solar cell according to the present invention is a manufacturing method for a perovskite solar cell including a photoelectric conversion layer containing a perovskite compound, the manufacturing method including: applying a precursor solution containing the perovskite compound as a solute over an application surface; applying a poor solvent having a lower solubility for the perovskite compound than a solubility for the perovskite compound of a solvent of the precursor solution over the application surface with the precursor solution applied; and ventilating a vicinity of the application surface at least between applying the precursor solution and applying the poor solvent.

In the manufacturing method for a perovskite solar cell according to the present invention, since the step of ventilating the vicinity of the application surface is included at least between the step of applying the precursor solution and the step of applying the poor solvent, the vicinity of the application surface is ventilated, thereby enabling the gas concentration of an organic compound in the vicinity of the application surface to be reduced. Thus, generation of pinholes in the photoelectric conversion layer can be suppressed.

Further, a control device according to the present invention controls an operation of the aforementioned manufacturing device for a perovskite solar cell. In this manner, for example, by controlling the operation of the ventilation unit, the vicinity of the application surface is ventilated, thereby enabling the gas concentration of an organic compound in the vicinity of the application surface to be reduced. As a result, generation of pinholes in the photoelectric conversion layer can be suppressed.

In some embodiments, in the control device according to the present invention, a ventilation amount by the ventilation unit is controlled based on a gas concentration of an organic compound in the vicinity of the application surface. In this manner, generation of pinholes in the photoelectric conversion layer can be suppressed and the surface roughness of the photoelectric conversion layer can be reduced.

In some embodiments, in the control device according to the present invention, the ventilation amount by the ventilation unit is controlled such that the gas concentration of the organic compound in the vicinity of the application surface falls within a preset range. **In** this manner, generation of pinholes in the photoelectric conversion layer can be further suppressed and the surface roughness of the photoelectric conversion layer can be reduced.

### Advantageous Effects of Invention

According to the present invention, generation of pinholes in a photoelectric conversion layer can be suppressed.

### Brief Description of Drawings

FIG. 1 is block diagram showing a manufacturing device for a perovskite solar cell according to a first embodiment;
FIG. 2 is a schematic view showing a perovskite crystalline structure;
FIG. 3 is a block diagram showing a manufacturing device for a perovskite solar cell according to a second embodiment;
FIG. 4 is a graph showing changes in a gas concentration over time when the gas concentration of an organic compound was changed by exhausting gas; and
FIG. 5 is a graph showing changes in a gas concentration over time when the gas concentration of an organic compound was changed by blowing air.

### Description of Embodiments

Hereinafter, with reference to the drawings, embodiments of a manufacturing device and a manufacturing method for a perovskite solar cell according to the present invention will be sequentially described. Note that the perovskite solar cell described in the embodiments includes a substrate, a first electrode layer (transparent electrode), a first carrier transport layer (hole transport layer or electron transport layer), a photoelectric conversion layer, a second carrier transport layer (electron transport layer or hole transport layer), and a second electrode layer (backside electrode).

Further, the manufacturing device for a perovskite solar cell described in the embodiments below is a device for manufacturing a perovskite solar cell including a photoelectric conversion layer containing a perovskite compound. Note that a roll-to-roll method will be described below, but the method in the manufacturing device for a perovskite solar cell is not limited to the roll-to-roll method.

### [First embodiment]

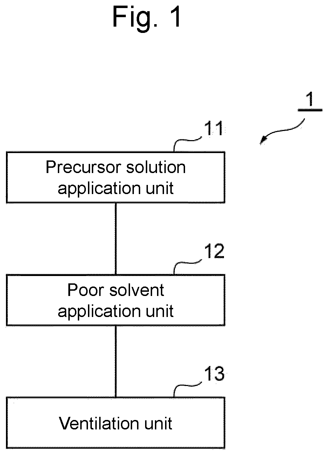

FIG. 1 is a block diagram showing a manufacturing device for a perovskite solar cell according to a first embodiment. As shown in FIG. 1, a manufacturing device 1 for a perovskite solar cell (hereinafter, simply referred to as a "manufacturing device 1") according to the present embodiment includes a precursor solution application unit 11, a poor solvent application unit 12, and a ventilation unit 13.

The precursor solution application unit 11 applies a precursor solution containing a perovskite compound as a solute over an application surface.

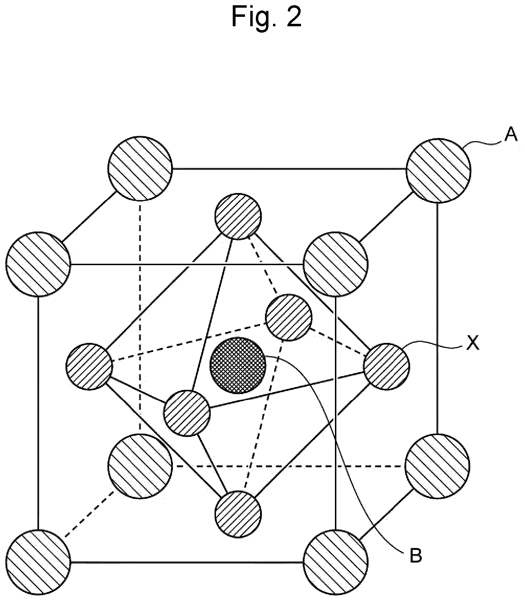

The perovskite compound is a compound having a perovskite crystalline structure. FIG. 2 is a schematic view showing the perovskite crystalline structure. As shown in FIG. 2, the perovskite crystalline structure has a unit cell of a cubic crystal system, where A is arranged at each vertex of the cubic crystal, B is arranged in the body center, and X is arranged at each face center of the cubic crystal having B at the center. The fact that the compound has a perovskite crystalline structure can be confirmed by, for example, an X-ray diffraction measurement.

The compositional formula of the perovskite compound can be represented by, for example, the following formula (1).

ABX₃ (1)

(In the formula, A is a monovalent cation, B is a divalent cation, and X is a monovalent anion.)

In some embodiments, A is at least one selected from a monovalent organic ammonium ion, a monovalent amidinium group ion, or a monovalent metal ion. Examples of the monovalent organic ammonium ion include CH₃NH₃⁺ (methylammonium ion: MA), C₂H₅NH₃⁺, C₃H₇NH₃⁺, and C₄H₉NH₃⁺. Examples of the monovalent amidinium group ion include HC(NH₂)₂⁺ (formamidinium ion: FA). Examples of the monovalent metal ion include a rubidium ion (Rb⁺) and a cesium ion (Cs⁺). In the formula (1), A may be a combination of the monovalent organic ammonium ion, the monovalent amidinium group ion, and the monovalent metal ion. In some embodiments, in the formula (1), A is MA, FA, or Cs⁺, and a combination of two or three thereof.

In some embodiments, in the formula (1), B is a divalent metal ion, for example, a lead ion (Pb²⁺), a tin ion (Sn²⁺), and a combination thereof. From the aspect of durability, B may be Pb²⁺.

In some embodiments, in the formula (1), X is a halogen ion, for example, at least one selected from a fluoride ion (F⁻), a chloride ion (Cl⁻), a bromide ion (Br⁻), or an iodide ion (I⁻), and X is Cl⁻, Br⁻, or I⁻.

As a method for applying the precursor solution, any method may be used as long as the method can uniformly apply the precursor solution over the application surface. Examples of the method for applying the precursor solution that can be used include a spin coating method, an inkjet method, a blade coating method, a die coating method, and a spray method. The precursor solution application unit 11 has a configuration corresponding to the method for applying the precursor solution to be used. For example, when the inkjet method is used as the method for applying the precursor solution, the precursor solution application unit 11 includes an inkjet head and applies the precursor solution over the surface (that is, application surface) of a first or a second carrier transport layer that is reeled out from a roll member.

The poor solvent application unit 12 applies a poor solvent over the application surface with the precursor solution applied. As with the precursor solution application unit 11, for example, the poor solvent application unit 12 includes, but not limited to, an inkjet head suitable for the inkjet method. That is, the poor solvent application unit 12 may be suitable for a blade coating method, a die coating method, or a spray method.

Here, the poor solvent is a solvent having a lower solubility for the perovskite compound than that of a solvent of the precursor solution, and may be a solvent that is substantially incapable of dissolving the perovskite compound. The poor solvent is a solvent, for example, having a solubility (the weight ratio of a solute to 100g of the solvent) for the perovskite compound at 25°C that is normally less than 1 weight % or may be less than 0.5 weight %.

The solvent that can be used as the poor solvent is not particularly limited, and examples thereof include a substituted aliphatic hydrocarbon such as dichloromethane and chloroform; an aromatic compound such as toluene, benzene, chlorobenzene, and tetralin; an ether such as diethyl ether and tetrahydrofuran (THF); an alcohol having 3 or more carbon atoms; a hydrocarbon having 4 to 10 carbon atoms; and an organic solvent such as acetic acid. Note that in the present invention, the aromatic compound also includes a compound partially including an aromatic ring. As the poor solvent, these solvents may be used individually or in combination of two or more of those. In one embodiment, the poor solvent is chlorobenzene.

The ventilation unit 13 ventilates the vicinity of the application surface. More specifically, the ventilation unit 13 ventilates the vicinity of the application surface so as to suppress an increase in the gas concentration of an organic compound in the vicinity of the application surface. That is, the ventilation unit 13 suppresses the increase in the gas concentration of the organic compound in the vicinity of the application surface by exchanging gas with a higher concentration of the organic compound in the vicinity of the application surface with gas with a lower concentration of the organic compound. The ventilation unit 13 may be in any configuration as long as it can appropriately ventilate the vicinity of the application surface. For example, the ventilation unit 13 may exhaust the vicinity of the application surface by exhausting the gas in the vicinity of the application surface or may ventilate the vicinity of the application surface by blowing air to the vicinity of the application surface.

The ventilation unit 13 includes, for example, an exhaust fan (exhaust section) that exhausts the gas in the vicinity of the application surface. The exhaust fan may be one or a plurality of those. In the case of a plurality of exhaust fans, the number of exhaust fans is determined based on the size of the application surface, the application speed of the precursor solution application unit 11, the gas concentration of the organic compound in the vicinity of the application surface, the room temperature, the humidity, and the like.

A place where the ventilation unit 13 is installed is not particularly limited as long as it can ventilate the vicinity of the application surface. For example, the ventilation unit 13 may be an exhaust fan installed above the application surface unless it interferes with the operation ranges of the precursor solution application unit 11 and the poor solvent application unit 12. Alternatively, the ventilation unit 13 may include a plurality of exhaust pipes disposed above or/and around the application surface and an exhaust fan that is connected to the exhaust pipes and is provided away from the application surface. Note that the vicinity of the application surface herein includes a projection area immediately above the application surface and the surrounding range of the projection area.

Further, the ventilation by the ventilation unit 13 only needs to be performed at least between application of the precursor solution and application of the poor solvent. Therefore, the ventilation may be performed between completion of application of the precursor solution by the precursor solution application unit 11 and start of application of the poor solvent by the poor solvent application unit 12, between start of application of the precursor solution by the precursor solution application unit 11 and start of application of the poor solvent by the poor solvent application unit 12, between completion of application of the precursor solution by the precursor solution application unit 11 and completion of application of the poor solvent by the poor solvent application unit 12, or between start of application of the precursor solution by the precursor solution application unit 11 and completion of application of the poor solvent by the poor solvent application unit 12.

Note that the organic compound referred to herein includes at least a solvent of the precursor solution, and may include a poor solvent or an organic compound unintentionally mixed therein. Here, it is assumed that in the vicinity of the application surface, the solvent included in the precursor solution is volatilized to be present in a gaseous form. Therefore, the gas concentration of the organic compound referred to herein may be interpreted as substantially the gas concentration of the solvent of the precursor solution.

Further, the vicinity of the application surface referred to herein may be defined as a region where the gas concentration of the organic compound measured in the region correlates with the volatilization rate of the solvent contained in a liquid film of the precursor solution positioned above the application surface. In one embodiment, the vicinity of the application surface refers to, for example, a region within 25 mm in a perpendicular direction from the application surface.

By controlling the gas concentration of the organic compound through ventilation by the ventilation unit 13, the solvent volatilizes at an appropriate volatilization rate from the coating film of the precursor solution formed on the application surface. As a result, a sufficient number of crystal nuclei of the perovskite compound are uniformly formed within the coating film of the precursor solution. By performing at least one of a drying step and an annealing step, crystal growth of the generated crystal nuclei of the perovskite compound is effected to form a photoelectric conversion layer. Therefore, with a sufficient number of crystal nuclei uniformly formed within the coating film of the precursor solution, generation of pinholes is suppressed, so that the photoelectric conversion layer uniformly containing the perovskite compound can be formed.

The manufacturing device 1 for a perovskite solar cell of the present embodiment includes the ventilation unit 13 that ventilates the vicinity of the application surface with the precursor solution applied, and thus, the vicinity of the application surface is ventilated so that the gas concentration of the organic compound in the vicinity of the application surface can be reduced. As a result, the crystal nuclei of the perovskite compound can be uniformly formed in the plane, so that generation of pinholes in the photoelectric conversion layer can be suppressed.

### [Manufacturing method for perovskite solar cell]

A manufacturing method for a perovskite solar cell (hereinafter, simply referred to as a "manufacturing method") according to the present embodiment is a method for manufacturing a perovskite solar cell including a photoelectric conversion layer containing a perovskite compound, using the aforementioned manufacturing device 1. The manufacturing method includes a precursor solution application step, a poor solvent application step, a ventilation step, a drying step, and an annealing step.

The precursor solution application step is a step of applying a precursor solution containing a perovskite compound as a solute. This precursor solution application step applies the aforementioned precursor solution over the surface (that is, application surface) of a first or a second carrier transport layer using the precursor solution application unit 11 under a dry air atmosphere or an inert gas atmosphere, for example.

The poor solvent application step is a step of applying a poor solvent over the application surface with the precursor solution applied. This poor solvent application step applies the poor solvent over the application surface using the poor solvent application unit 12.

The ventilation step is a step of ventilating the vicinity of the application surface using the ventilation unit 13, and is performed at least between the precursor solution application step and the poor solvent application step. Therefore, the ventilation step may be performed between completion of application of the precursor solution and start of application of the poor solvent, between start of application of the precursor solution and start of application of the poor solvent, between completion of application of the precursor solution and completion of application of the poor solvent, or between start of application of the precursor solution and completion of application of the poor solvent.

The drying step is a step of removing the solvent in the coating film and growing the perovskite crystals. This drying step removes the solvent in the coating film using, for example, a publicly-known drying method, such as a heating method, a dry gas spraying method, or a vacuuming method.

In the annealing step, typically, the coating film is heated at a temperature equal to or higher than 70°C and equal to or lower than 200°C. This annealing step can also be performed as one step together with the drying step.

By performing the aforementioned steps, the photoelectric conversion layer containing the perovskite compound is formed. Note that since the layers other than the photoelectric conversion layer can be formed using a publicly-known method, the descriptions are omitted.

Since the manufacturing method according to the present embodiment includes the ventilation step that ventilates the vicinity of the application surface at least between the precursor solution application step and the poor solvent application step, the vicinity of the application surface is ventilated so that the gas concentration of the organic compound in the vicinity of the application surface can be reduced. As a result, generation of pinholes in the photoelectric conversion layer can be suppressed.

### [Second embodiment]

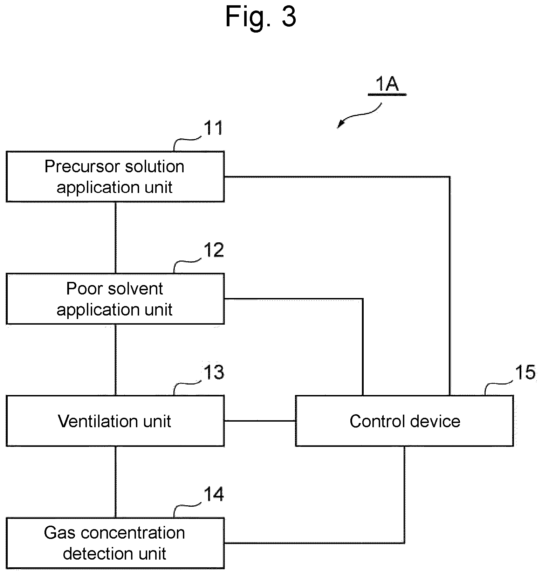

Hereinafter, with reference to FIG. 3, a second embodiment of a manufacturing device for a perovskite solar cell will be described. A manufacturing device 1A of the present embodiment differs from the aforementioned first embodiment in that it further includes a gas concentration detection unit 14 and a control device 15. The other structures are the same as those of the first embodiment, and thus, the overlapping descriptions will be omitted.

The gas concentration detection unit 14 detects the gas concentration in the vicinity of the application surface. The gas concentration detection unit 14 includes, for example, a volatile organic compound (VOC) concentration meter, and may be a VOC concentration meter using a photoionization detector (PID). The gas concentration detection unit 14 is electrically connected to the control device 15 and outputs the detection results to the control device 15.

The control device 15 includes, for example, a microcomputer of a combination of a CPU (Central Processing Unit) that performs operations, a ROM (Read Only Memory) as a secondary storage that records programs for the operations, and a RAM (Random Access Memory) as a primary storage that stores the operation history and temporary control variables, and controls each of the components of the manufacturing device 1 by performing the stored programs. Note that the control device 15 may be configured to be independent of the manufacturing device 1. That is, the control device 15 may be a control device that controls the operation of the manufacturing device 1. For example, the control device 15 may be a computer that controls the operations or the like of the components of the manufacturing device 1, externally from the manufacturing device 1A.

For example, the control device 15 controls actuation or stop timing, an application amount, an application range, and the like of each of the precursor solution application unit 11 and the poor solvent application unit 12. Further, the control device 15 controls actuation or stop timing or the like of the ventilation unit 13. Further, the control device 15 controls a ventilation amount by the ventilation unit 13 based on the gas concentration of an organic compound in the vicinity of the application surface detected by the gas concentration detection unit 14.

The control of the ventilation amount by the control device 15 is performed based on, for example, a table, a graph, or the like, which is stored in the control device 15 in advance, showing the correlation between the gas concentration of an organic compound and the ventilation amount by the ventilation unit 13 (more specifically, the correlation between the gas concentration of the organic compound and the number of rotation of the exhaust fan). The table, the graph, or the like showing the correlation is obtained using, for example, empirical values and actually measured values.

In the present embodiment, the control device 15 may control the ventilation amount by the ventilation unit 13 such that the gas concentration of the organic compound in the vicinity of the application surface falls within a preset range. The preset range may be 1000 ppm to 4000 ppm of the gas concentration of the organic compound in the vicinity of the application surface at timing of starting application of the poor solvent, for example. With such a range, generation of pinholes in the photoelectric conversion layer can be suppressed and the surface roughness of the photoelectric conversion layer can be reduced.

According to the manufacturing device 1A of the present embodiment, the same function and effect as those of the aforementioned first embodiment can be obtained, and in addition, since it further includes the gas concentration detection unit 14 and the control device 15, the following function and effect can be further obtained. That is, the control device 15 controls the ventilation amount by the ventilation unit 13 based on the gas concentration, which is detected by the gas concentration detection unit 14, of the organic compound in the vicinity of the application surface, so as to be able to control the volatilization rate of the solvent in the coating film to be within an appropriate range. Accordingly, generation of pinholes in the photoelectric conversion layer can be suppressed and the surface roughness of the photoelectric conversion layer can be reduced. As a result, the quality of the perovskite crystal can be improved.

Note that the manufacturing method using the manufacturing device 1A differs from the aforementioned manufacturing method in that the control device controls, in the ventilation step, the ventilation amount by the ventilation unit 13 based on the detection results of the gas concentration detection unit 14, but the other matters are the same, and thus, the overlapping descriptions are omitted.

### [Third embodiment]

A manufacturing device 1B of a third embodiment differs from the aforementioned second embodiment in that it performs ventilation using a blower. The other structures are the same as those of the second embodiment, and thus, the overlapping descriptions will be omitted.

That is, in the present embodiment, the ventilation unit 13 includes a blower (air blowing section) that blows air to the vicinity of the application surface. The blower is electrically connected to the control device 15 and is controlled by the control device 15. Further, the control device 15 controls the blown air volume of the blower based on the gas concentration, which is detected by the gas concentration detection unit 14, of the organic compound in the vicinity of the application surface.

According to the manufacturing device 1B of the present embodiment, the same function and effect as those of the aforementioned second embodiment are obtained, and in addition, since the ventilation unit 13 includes the blower, the variation of the ventilation unit 13 can be increased. As a result, the versatility of the manufacturing device 1B can be increased.

Hereinafter, the present invention will be described using examples, but the present invention is not limited to the range of the examples. Further, comparative examples compared with the examples will also be described.

First, a stacked body in which a glass plate, a fluorine-doped tin oxide (FTO) film (transparent conductive film), and a titanium oxide (TiO₂) layer (electron transport layer) were stacked in this order was used as a substrate. Further, as a precursor solution, a solution was prepared by dissolving a ternary CsFAMAPbI₃ in a solvent including DMF and DMSO.

Next, under a nitrogen gas atmosphere and at room temperature (25°C), the prepared precursor solution was applied over a surface (application surface) of an electron transport layer of the substrate, with the gas concentration of an organic compound changed during the application. Further, a poor solvent was dropped onto the applied precursor solution and annealing treatment was performed to form a perovskite film containing a perovskite compound on the substrate so that a photoelectric conversion layer was formed. The gas concentration of the organic compound was changed during the application by exhausting gas or blowing air. The gas concentration of the organic compound was detected using a PID VOC concentration meter (gas concentration meter) installed at a position immediately above the application surface.

### [Gas concentration change by exhausting gas (Examples 1 to 6 and Comparative Examples 1 and 2)]

Next, a plurality of slit openings was provided in a lid of a spin coater so as to be in parallel to the application surface, and was coupled to an exhaust valve via a pipe and a ventilation mechanism to ventilate the inside of the spin coater by operating the exhaust valve was added to the spin coater. The gas inside the spin coater was exhausted using the ventilation mechanism, by setting the exhaust amount by means of the exhaust valve at three levels of "small," "medium," and "large." The experiment was conducted twice for each exhaust condition.

The perovskite film was formed by the following procedure.
1. Start exhausting gas
2. Set a substrate on a spin coater stage
3. Drop a precursor solution onto the substrate
4. Start rotation of the spin coater
5. Drop chlorobenzene (poor solvent) using a pipette during the rotation
6. Terminate the rotation of the spin coater
7. Remove the substrate and place it on a hot plate to perform an annealing process (120°C)

### [Gas concentration change by blowing air (Examples 7 and 8)]

A circulator was placed at a position approximately 15 cm away from a substrate in a horizontal direction, and air was blown to the substrate using the circulator. The blown air volume of the circulator was set at two levels of "large" and "small."

The perovskite film was formed by the following procedure.
1. Start blowing air
2. Set a substrate on a spin coater stage
3. Drop a precursor solution onto the substrate
4. Start rotation of the spin coater
5. Drop chlorobenzene (poor solvent) using a pipette during the rotation
6. Terminate the rotation of the spin coater
7. Remove the substrate and place it on a hot plate to perform an annealing process (120°C)

Next, the following analyses were performed on the perovskite film formed on the substrate.

### [Pinhole measurement]

An image of the perovskite film was obtained using a transmission illumination type digital microscope. The obtained image was observed while applying light from a side opposite to the lens, and the visualized pinhole portion was subjected to an image analysis to measure the area (total area) and the number of the pinhole portions.

### [Calculation of surface roughness Sa]

The surface of the perovskite film was observed using a white-light interference microscope, and a surface roughness Sa was calculated.

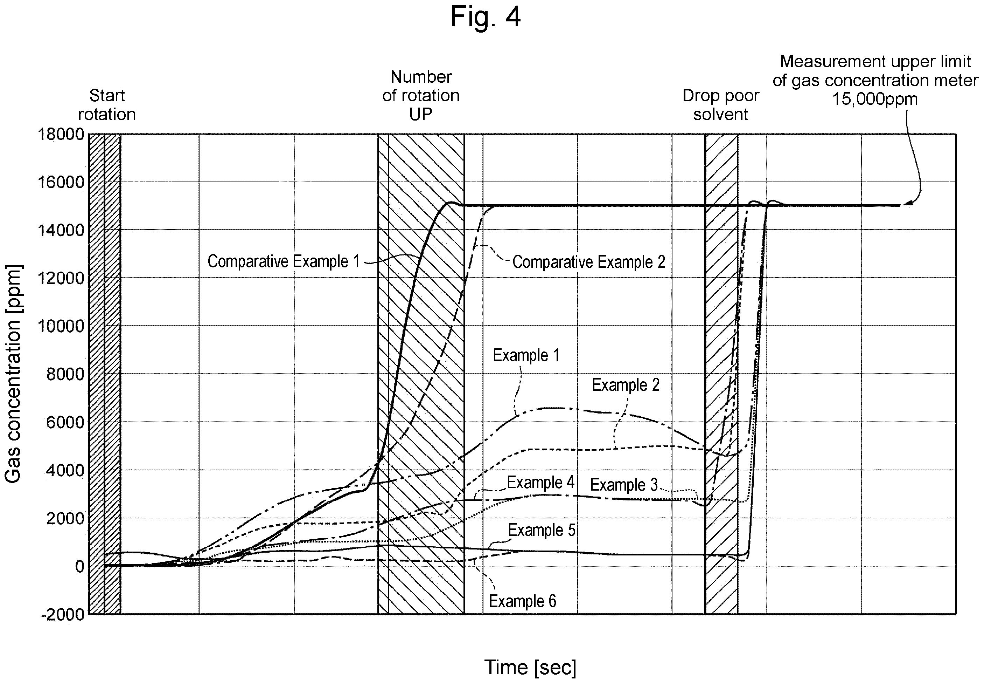

Table 1 shows analysis results of the perovskite film when the gas concentration of the organic compound was changed by exhausting gas. Further, FIG. 4 is a graph showing changes in the gas concentration over time when the gas concentration of the organic compound was changed by exhausting gas.

**[Table 1]**

| | Gas Exhausting Condition | Pinholes | | |
|---|---|---|---|---|
| | | Area [µm²] | Count [Number] | Sa [nm] |
| Comparative Example 1 | None | 1184281 | 133 | - |
| Comparative Example 2 | None | 807940 | 80 | - |
| Example 1 | Small | 76785 | 18 | 8.165091 |
| Example 2 | Small | 42641 | 10 | 10.14171 |
| Example 3 | Medium | 1948 | 1 | 11.91161 |
| Example 4 | Medium | 0 | 0 | 9.630444 |
| Example 5 | Large | 0 | 0 | 26.90895 |
| Example 6 | Large | 0 | 0 | 31.00589 |

As shown in FIG. 4, when the gas was not exhausted (Comparative Examples 1 and 2), the gas concentration reached a measurement upper limit of the gas concentration meter (i.e., detection upper value, 15000 ppm) before dropping the poor solvent. Therefore, in Comparative Examples 1 and 2, the gas concentration before dropping the poor solvent was higher than 15000 ppm. Meanwhile, in Examples 1 to 6, the gas concentration of the organic compounds significantly increased after dropping the poor solvent. This shows that the gas concentration of the organic compound before dropping the poor solvent corresponds to the concentration of gas formed by volatilization of the solvent of the precursor solution, and the gas concentration of the organic compound after dropping the poor solvent corresponds to a sum of the concentration of the gas formed by volatilization of the solvent of the precursor solution and a poor solvent gas formed by volatilization of the poor solvent.

Further, as shown in Table 1, in Comparative Examples 1 and 2, a large number of pinholes were generated in the perovskite film. This is presumably because the high gas concentration in the environment caused a slow and uneven volatilization of the solvent in the coating film, which led to a non-uniform formation of crystal nuclei in the plane, resulting in a state in which perovskite crystals were not formed in some parts.

Further, as shown in FIG. 4, when the amount of the gas exhausted was "small" and "medium" (Examples 1, 2, and Examples 3, 4, respectively), the generated solvent gas was exhausted, and therefore, the gas concentration in the environment was reduced as compared to the case where the gas was not exhausted. As shown in Table 1, in Examples 1 to 4, the formation of pinholes was suppressed by appropriate volatilization of the solvent in the coating film.

Furthermore, when the amount of the gas exhausted was "large" (Examples 5 and 6), the gas concentration in the environment was significantly reduced. As shown in Table 1, in Examples 5 and 6, the formation of pinholes was significantly suppressed and no pinholes were observed by the microscope observation, but the values of the surface roughness Sa were increased. It is presumably because the low gas concentration in the environment caused rapid volatilization of the solvent in the coating film, which led to an uneven crystal nuclei formation or crystal growth in the plane, causing the crystals to be partially raised and thus increasing the surface unevenness.

The above results show that, in the film formation of the perovskite film, the quality of the perovskite crystal is improved by maintaining appropriate gas concentration of the organic compound at the timing of application of the poor solvent.

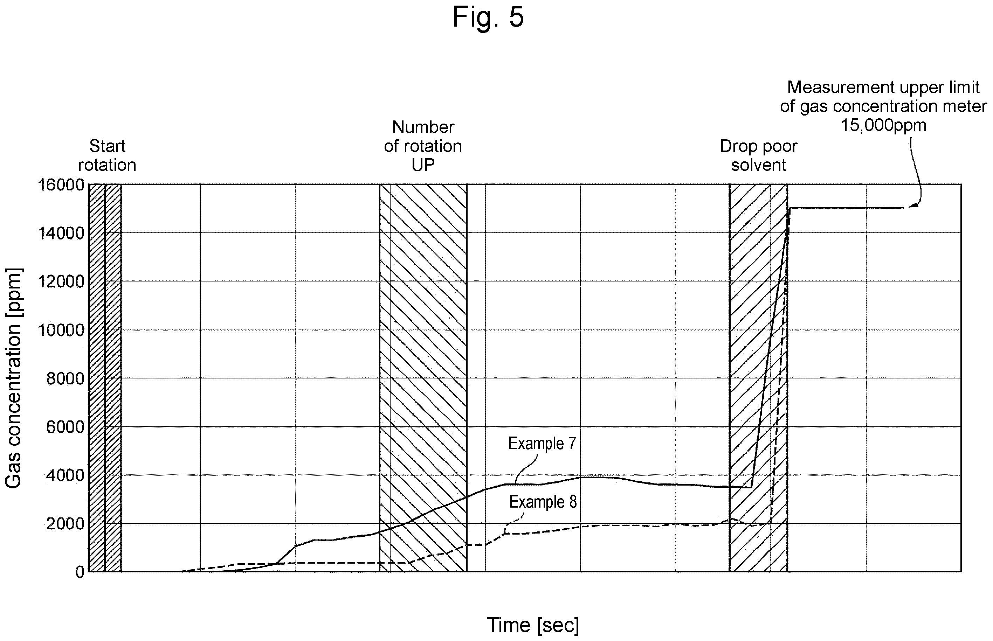

Table 2 shows analysis results of the perovskite film when the gas concentration of the organic compound was changed by blowing air. FIG. 5 is a graph showing changes in the gas concentration over time when the gas concentration of the organic compound was changed by blowing air.

**[Table 2]**

| | Air Blowing Condition | Pinholes | | |
|---|---|---|---|---|
| | | Area [µm²] | Count [Number] | Sa [nm] |
| Example 7 | Small | 0 | 0 | 12.93976 |
| Example 8 | Large | 0 | 0 | 14.55672 |

As shown in Table 2 and FIG. 5, the formation of pinholes was suppressed, and further, the value of the surface roughness Sa was also sufficiently small by maintaining appropriate gas concentration of the organic compound at the timing of application of the poor solvent.

The embodiments of the present invention have been described in detail above, but the present invention is not limited to the aforementioned embodiments and various design changes can be made within the scope without departing from the spirit of the present invention described in the claims.

For example, the ventilation unit 13 may include both the exhaust fan and the blower.

### Reference Signs List

- 1, 1A, 1B: Manufacturing device for perovskite solar cell
- 11: Precursor solution application unit
- 12: Poor solvent application unit
- 13: Ventilation unit
- 14: Gas concentration detection unit
- 15: Control device

## Claims

1. A manufacturing device for a perovskite solar cell (1, 1A, 1B) including a photoelectric conversion layer containing a perovskite compound, the manufacturing device comprising:
a precursor solution application unit (11) that applies a precursor solution containing the perovskite compound as a solute over an application surface;
a poor solvent application unit (12) that applies a poor solvent having a lower solubility for the perovskite compound than a solubility for the perovskite compound of a solvent of the precursor solution over the application surface with the precursor solution applied; and
a ventilation unit (13) that ventilates a vicinity of the application surface.

2. The manufacturing device for a perovskite solar cell (1, 1A, 1B) according to claim 1, further comprising:
a gas concentration detection unit (14) that detects a gas concentration of an organic compound in the vicinity of the application surface; and
a control device (15) that controls a ventilation amount by the ventilation unit (13),
wherein the control device (15) controls the ventilation amount by the ventilation unit (13) based on the gas concentration of the organic compound in the vicinity of the application surface detected by the gas concentration detection unit.

3. The manufacturing device for a perovskite solar cell (1, 1A, 1B) according to claim 2, wherein the control device (15) controls the ventilation amount by the ventilation unit (13) such that the gas concentration of the organic compound in the vicinity of the application surface falls within a preset range.

4. The manufacturing device for a perovskite solar cell (1, 1A, 1B) according to any one of claims 1 to 3, wherein the ventilation unit (13) comprises an exhaust section that exhausts gas in the vicinity of the application surface.

5. The manufacturing device for a perovskite solar cell (1, 1A, 1B) according to any one of claims 1 to 3, wherein the ventilation unit (13) comprises an air blowing section that blows air to the vicinity of the application surface.

6. A manufacturing method for a perovskite solar cell including a photoelectric conversion layer containing a perovskite compound, the manufacturing method comprising:
applying a precursor solution containing the perovskite compound as a solute over an application surface;
applying a poor solvent having a lower solubility for the perovskite compound than a solubility for the perovskite compound of a solvent of the precursor solution over the application surface with the precursor solution applied; and
ventilating a vicinity of the application surface at least between applying the precursor solution and applying the poor solvent.

7. A control device (15) adapted to control an operation of the manufacturing device for a perovskite solar cell (1, 1A, 1B) according to claim 1.

8. The control device (15) according to claim 7, wherein a ventilation amount by the ventilation unit (13) is controlled based on a gas concentration of an organic compound in the vicinity of the application surface.

9. The control device (15) according to claim 8, wherein the ventilation amount by the ventilation unit (13) is controlled such that the gas concentration of the organic compound in the vicinity of the application surface falls within a preset range.
